# EUROPÄISCHE PATENTANMELDUNG

(11) **EP 3 651 032 A1**
(43) Veröffentlichungstag der Anmeldung: **13.05.2020**
(21) Anmeldenummer: 18204591.4
(22) Anmeldetag: 06.11.2018
(51) Int. Cl.: G06F 17/50

(54) **VERFAHREN UND VORRICHTUNG ZUM BEREITSTELLEN EINES AKTUALISIERTEN DIGITALEN GEBÄUDEMODELLS**

(71) Anmelder: Siemens Schweiz AG, 8047 Zürich (CH)
(72) Erfinder: Frey, Christian, 6314 Unterägeri (CH); Klein, Wolfram, 85579 Neubiberg (DE); Mayer, Hermann Georg, 83209 Prien am Chiemsee (DE)
(74) Vertreter: Maier, Daniel Oliver

(57) **Zusammenfassung**

Es wird ein Verfahren zum Bereitstellen eines aktualisierten digitalen Gebäudemodells vorgeschlagen. Das Verfahren umfasst die folgenden Schritte:
a) Bereitstellen (101) eines digitalen Gebäudemodells für ein physikalisches Gebäude,
b) Ermitteln (102) einer virtuell begehbaren Fläche innerhalb des digitalen Gebäudemodells,
c) Erfassen von Realdaten (103), welche mittels einer Anzahl N von Datenquellen erhalten werden, mit N ≥ 1, wobei die Realdaten Daten von einer mit der virtuell begehbaren Fläche korrespondierenden realen begehbaren Fläche innerhalb des physikalischen Gebäudes umfassen, und
d) Aktualisieren (104) der virtuell begehbaren Fläche innerhalb des digitalen Gebäudemodells mittels der erfassten Realdaten der realen begehbaren Fläche zur Bereitstellung des aktualisierten digitalen Gebäudemodells.

Hierdurch liegen bei dem Erfordernis einer Evakuierung eines physikalischen Gebäudes, aktualisierte virtuell begehbare Flächen vor, und somit kann darauf basierend ein aktualisierter Evakuierungsplan zur Evakuierung von Personen bereitgestellt werden. Dies erhöht die Sicherheit für Personen im physikalischen Gebäude.

## Beschreibung

Die vorliegende Erfindung betrifft ein Verfahren sowie ein Computerprogrammprodukt zum Bereitstellen eines aktualisierten digitalen Gebäudemodells. Des Weiteren betrifft die vorliegende Erfindung eine Vorrichtung zum Bereitstellen eines aktualisierten digitalen Gebäudemodells.

Das technische Gebiet der Erfindung betrifft die Bereitstellung eines aktualisierten digitalen Gebäudemodells, insbesondere die Bereitstellung aktualisierter virtuell begehbarer Flächen innerhalb des aktualisierten digitalen Gebäudemodells.

Heutige zu bauende physikalische Gebäude werden insbesondere durch Architekten mittels "Computer Aided Design"(CAD)-Tools digital modelliert, um ein digitales Gebäudemodell von dem zu bauenden physikalischen Gebäude zu erhalten.

Das auf diese Weise erhaltene digitale Gebäudemodell wird insbesondere mittels "Building Information Modeling" (BIM) und das dazugehörige Datenformat zur Beschreibung von BIM, nämlich "Industry Foundation Classes" (IFC), oder aber auch in ein herstellerspezifisches Format wie das Revit-Format konvertiert. Mittels der dadurch entstandenen BIM/IFC-Daten wird somit insbesondere vor dem Baubeginn ein digitales Abbild des zu bauenden physikalischen Gebäudes erstellt. Das digitale Abbild, also das digitale Gebäudemodell in BIM/IFC-Daten, wird hierbei als sogenannter digitaler Zwilling ("Digital Twin") beschrieben.

Solche digitalen Gebäudemodelle werden insbesondere dazu verwendet, um ein Personenstromflussverhalten in einem zu bauenden physikalischen Gebäude und/oder in einem vorhandenen physikalischen Gebäude zu simulieren und zu untersuchen. Bei der Simulation des Personenstromflussverhaltens ist es vorteilhaft, dass die virtuell begehbaren Flächen des digitalen Gebäudemodells möglichst mit den realen begehbaren Flächen des physikalischen Gebäudes übereinstimmen. Die begehbaren Flächen sind beispielsweise Räume, Flure, Gänge, Treppen und Aufzüge. Je aktueller und exakter die Daten der virtuell begehbaren Flächen in Bezug auf die korrespondierenden realen begehbaren Flächen vorhanden sind, desto besser kann das Personenstromflussverhalten simuliert und untersucht werden.

Durch bauliche Veränderungen an dem physikalischen Gebäude kann der Status der BIM/IFC-Daten des digitalen Gebäudemodells veraltet sein. Auch ist es möglich, dass bei der Erstellung des digitalen Gebäudemodells virtuell begehbare Flächen oder die Begehbarkeit von einzelnen virtuell begehbaren Flächen nicht exakt erfasst worden sind. Weiterhin können begehbare Flächen im digitalen Gebäudemodell zwar vorhanden sein, sind aber in der Realität für Personen ohne besondere Berechtigung gesperrt (Sperrflächen, wie insbesondere in Flughäfen). Aus diesen Gründen können die virtuell begehbaren Flächen nicht mehr mit den realen begehbaren Flächen übereinstimmen.

Um trotzdem eine möglichst hohe Übereinstimmung zu erreichen, sind aus dem Stand der Technik zumindest zwei Möglichkeiten bekannt.

Bei einer ersten Möglichkeit wird durch manuelles Auslesen von virtuell begehbaren Flächen versucht, eine hohe Übereinstimmung zu erreichen. Dabei werden beispielsweise Daten über und zwischen zwei digitalen Stockwerken aus den BIM/IFC-Daten ausgelesen, um eine Treppe vollständig digital konstruieren zu können. Dabei wird angenommen, dass die BIM/IFC-Daten des digitalen Gebäudemodells den realen Daten des physikalischen Gebäudes entsprechen. Diese Methodik kann beispielsweise semantisch inkorrekt und die BIM/IFC-Daten des digitalen Gebäudemodells können veraltet sein.

Bei einer zweiten Möglichkeit werden eine manuelle Begehung und Vermessung des physikalischen Gebäudes vor Ort durch Personen durchgeführt, was wiederum einen hohen Zeit- und Kostenaufwand mit sich trägt.

Vor diesem Hintergrund besteht eine Aufgabe der vorliegenden Erfindung darin, eine Datenbasis für ein digitales Gebäudemodell zu schaffen, welche zu einem verbesserten aktualisierten digitalen Gebäudemodell führt.

Gemäß einem ersten Aspekt wird ein Verfahren zum Bereitstellen eines aktualisierten digitalen Gebäudemodells vorgeschlagen. Das Verfahren umfasst dabei die folgenden Schritte:
a) Bereitstellen eines digitalen Gebäudemodells für ein physikalisches Gebäude,
b) Ermitteln einer virtuell begehbaren Fläche innerhalb des digitalen Gebäudemodells,
c) Erfassen von Realdaten, welche mittels einer Anzahl N von Datenquellen erhalten werden, mit N ≥ 1, wobei die Realdaten Daten von einer mit der virtuell begehbaren Fläche korrespondierenden realen begehbaren Fläche innerhalb des physikalischen Gebäudes umfassen, und
d) Aktualisieren der virtuell begehbaren Fläche innerhalb des digitalen Gebäudemodells mittels der erfassten Realdaten der realen begehbaren Fläche zur Bereitstellung des aktualisierten digitalen Gebäudemodells.

Nach Durchführung des beanspruchten Verfahrens weist das aktualisierte digitale Gebäudemodell aktualisierte virtuell begehbare Flächen auf. Durch die Aktualisierung der virtuell begehbaren Flächen sind beispielsweise veraltete virtuell begehbare Flächen, welche beispielsweise in dem aktualisierten digitalen Gebäudemodell nicht mehr vorhanden sind, da diese auch in dem physikalischen Gebäude nicht mehr vorhanden sind, in den aktualisierten virtuell begehbaren Flächen als Hindernisse oder als nicht virtuell begehbare Flächen dargestellt. Basierend auf dem aktualisierten digitalen Gebäudemodell kann eine aktualisierte Personenstromsimulation durchgeführt werden, dessen Ergebnis mit einer vor der Aktualisierung des digitalen Gebäudemodells durchgeführten früheren Personenstromsimulation verglichen wird.

Falls nun eine Abweichung der virtuell begehbaren Flächen zwischen der früheren Personenstromsimulation und der aktualisierten Personenstromsimulation auftritt oder einen vorbestimmten Wert überschreitet, wird vorzugsweise eine Sicherheitswarnung an die für das physikalische Gebäude zuständige Institution abgesetzt. Diese Abweichung kommt insbesondere durch veränderte reale begehbare Flächen in dem physikalischen Gebäude zustande. Dies führt dazu, dass basierend auf der Sicherheitswarnung entsprechende Maßnahmen zur Gewährleistung der Sicherheit im physikalischen Gebäude vorsorglich ergriffen werden können.

Das hat den Vorteil, dass bei dem Erfordernis einer Evakuierung eines physikalischen Gebäudes, aktualisierte virtuell begehbare Flächen vorliegen, und somit darauf basierend ein aktualisierter Evakuierungsplan zur Evakuierung von Personen bereitgestellt werden kann. Dies erhöht die Sicherheit für Personen in dem physikalischen Gebäude, da im Evakuierungsfall eine schnellere und unproblematischere Evakuierung der Personen durchgeführt werden kann.

Ein weiterer Vorteil ist, dass virtuell begehbare Flächen, wie beispielsweise Treppen, erst durch Hinzunahme von den erfassten Realdaten optimal modelliert werden können. Dadurch können weitere Simulationsmodelle an die aktuelle Situation angepasst und somit verbessert werden.

Das Bereitstellen umfasst insbesondere ein mittels "Computer Aided Design"(CAD)-Tools digital modelliertes Gebäude, welches als digitales Gebäudemodell ausgebildet ist. Weiterhin umfasst das Bereitstellen als nächstes eine Konvertierung des digitalen Gebäudemodells insbesondere in ein "Building Information Modeling"(BIM)/"Industry Foundation Classes"(IFC)-Format, vorzugsweise in BIM/IFC-Daten. Das digitale Gebäudemodell kann insbesondere für ein noch zu bauendes physikalisches Gebäude und/oder für ein bereits gebautes physikalisches Gebäude bereitgestellt werden.

Das physikalische Gebäude kann auch als reales Gebäude oder als physisches Gebäude bezeichnet werden.

Die virtuell begehbare Fläche kann insbesondere als eine digitale begehbare Fläche bezeichnet werden.

Realdaten sind Daten und/oder Datensätze, welche insbesondere mittels einer oder mehreren Datenquellen erhalten werden. Datenquellen umfassen Informationen, welche insbesondere aus realen begehbaren Flächen und/oder dem physikalischen Gebäude und/oder aus Gebäudeteilen des physikalischen Gebäudes erhalten werden.

Das Aktualisieren umfasst vorzugsweise, dass die erfassten Realdaten, insbesondere die Realdaten aus den realen begehbaren Flächen, mit dem digitalen Gebäudemodell, insbesondere mit den virtuell begehbaren Flächen, zusammengeführt werden. Im Detail entspricht die Aktualisierung des digitalen Gebäudemodells insbesondere einer Datenfusion, also einer Datenzusammenführung, von den einerseits erfassten Realdaten aus dem physikalischen Gebäude mit den andererseits früheren virtuell begehbaren Flächen innerhalb des digitalen Gebäudemodells, um als Ergebnis der Datenfusion ein aktualisiertes digitales Gebäudemodell bereitzustellen.

Das beanspruchte Verfahren kann insbesondere auch für die Verbesserung von Energiesimulationsmodellen und/oder Innenraumlichtsimulationsmodellen dienlich sein. Weitere Simulationsmodelle, wie beispielsweise Akustiksimulationen, sind denkbar.

Gemäß einer Ausführungsform wird die virtuell begehbare Fläche des digitalen Gebäudemodells mittels digitaler Planungsdaten aus dem digitalen Gebäudemodell ermittelt, und/oder mittels eines Scanverfahrens, bei welchem die reale begehbare Fläche innerhalb des physikalischen Gebäudes gescannt wird, aus dem physikalischen Gebäude ermittelt, und/oder mittels zumindest einer mobilen Datenquelle, welche Bewegungsdaten von zumindest einem Benutzer der realen begehbaren Fläche innerhalb des physikalischen Gebäudes bereitstellt, aus dem physikalischen Gebäude ermittelt.

Das Ermitteln umfasst insbesondere ein Extrahieren der gewünschten virtuell begehbaren Flächen innerhalb des digitalen Gebäudemodells aus dem digitalen Gebäudemodell mittels unterschiedlicher in dieser Ausführungsform beschriebenen Methoden.

Die digitalen Planungsdaten sind beispielsweise Daten, welche aus einem digitalen Gebäudemodell extrahiert und/oder gewonnen werden können. Digitale Planungsdaten sind beispielsweise im BIM-, IFC-, und/oder im herstellerspezifischen Revit(Autodesk)-Format vorhanden. Die digitalen Planungsdaten umfassen insbesondere die virtuell begehbaren Flächen des digitalen Gebäudemodells.

Insbesondere gibt es in einem mittels IFC beschriebenen digitalen Gebäudemodell Objektklassen wie "IFC-Slabs", die ein Stockwerk eines digitalen Gebäudes repräsentieren, "IFC-Stairs", welche die Treppen digital repräsentieren, und "IFC-Walls", welche die Wände und/oder Hindernisse digital repräsentieren. Mittels dieser drei IFC-Elemente ist es beispielsweise möglich, die virtuell begehbaren Flächen aus dem digitalen Planungsdaten zur Verwendung für das digitale Gebäudemodell zu ermitteln.

Bei dem Scanverfahren werden insbesondere mittels Laserscannern, wie beispielsweise einem Roboter mit einem Laserscanner, vorzugsweise die realen begehbaren und realen nichtbegehbaren Flächen des physikalischen Gebäudes, wie beispielsweise Fußböden, Wände, Türen, Treppen und/oder Aufzüge gescannt. Das physikalische Gebäude wird anschließend als eine Punktewolke digital abgespeichert. Andere Scanverfahren und Scangeräte sind denkbar. Mittels weiterer Softwareverfahren können anschließend aus der Punktewolke Informationen extrahiert werden, welche die realen begehbaren Flächen betreffen. Somit werden insbesondere Informationen darüber erhalten, welche Punkte der Punktewolke eine Wand, den Fußboden, die Treppe und/oder den Aufzug repräsentieren.

Die mobile Datenquelle bezeichnet insbesondere eine Quelle, die ihre mobilen Daten mittels eines mobilen Endgeräts, wie beispielsweise einem Smartphone, einem Tablet und/oder einem tragbaren elektronischen Gerät, erhält. Mittels dieses mobilen Endgerätes werden, sofern ein Benutzer das Gerät bei sich trägt und der Benutzer innerhalb des physikalischen Gebäudes sich bewegt sowie eine Aufzeichnung von mobilen Daten auf dem mobilen Endgerät aktiviert ist, mobile Daten aufgezeichnet. Mobile Daten umfassen insbesondere Daten, welche mittels unterschiedlicher auf dem und/oder in dem mobilen Endgerät eingebauter mobiler Sensoren erhalten werden. Mobile Sensoren umfassen beispielsweise Kamerasensorik, Beschleunigungssensorik und/oder eine Installation eines mobilen Sensors, beispielsweise in einem Putzwagen, welcher in dem physikalischen Gebäude bewegt wird. Weitere mobile Sensoren in einem mobilen Endgerät sind denkbar. Zusätzlich umfassen mobile Daten insbesondere Daten, bei welchen über einen oder mehrere Mobilfunkmasten, GPS-Sensorik und/oder GLONASS-Sensorik und/oder anderen Satellitensystemen oder Positionsbestimmungssystemen ein Bewegungsprofil und/oder Positionsdaten des Benutzers des mobilen Endgerätes bei einer Bewegung innerhalb des physikalischen Gebäudes bestimmt werden. Hierzu zählen ebenfalls insbesondere Indoor-Positionsverfahren basierend auf in dem physikalischen Gebäude installierten Beacons oder WLAN-Verbindungen zwischen einem mobilen Endgerät und mit einem in dem physikalischen Gebäude installierten Router, um beispielsweise Bewegungsprofile des Benutzers erstellen zu können.

Gemäß einer weiteren Ausführungsform ist jede der N Datenquellen als ein bestimmter Datenquellentyp ausgebildet, wobei der bestimmte Datenquellentyp die mobile Datenquelle oder eine verbaute Datenquelle umfasst.

Die verbaute Datenquelle bezeichnet insbesondere eine Quelle, welche ihre verbauten Daten mittels verbauter Sensorik, insbesondere verbauter Sensoren erhält.

Die verbauten Sensoren umfassen vorzugsweise Sensoren, welche in Bauteilen und/oder Geräten, welche in physikalischen Gebäuden installiert oder angebracht sind. Zu den verbauten Sensoren zählen beispielsweise Videokameras, Fenstersensoren, Türsensoren, Sensoren, welche in einem Gebäudeleittechniksystem integriert sind, Brandschutztüren, Zutrittskontrollen. Weitere innerhalb eines physikalischen Gebäudes installierte und/oder integrierte Sensoren sind denkbar.

Gemäß einer weiteren Ausführungsform ist die Anzahl N von Datenquellen N ≥ 2.

Gemäß einer weiteren Ausführungsform wird jeder der N Datenquellen eine jeweilige Priorität zugeordnet, wobei zumindest eine der N Datenquellen in Abhängigkeit der zugeordneten Prioritäten zum Erfassen der Realdaten ausgewählt wird.

Gemäß einer weiteren Ausführungsform wird als die Priorität eine zeitliche Priorität zur Angabe einer Aktualität der von der Datenquelle erhaltenen Realdaten verwendet, wobei zumindest eine der N Datenquellen in Abhängigkeit der zugeordneten zeitlichen Prioritäten zum Erfassen der Realdaten ausgewählt wird.

Bei der zeitlichen Priorität wird insbesondere aus allen N Datenquellen der Zeitstempel der Datengenerierung evaluiert und verglichen. Insbesondere haben die N Datenquellen mit der aktuellsten Erstellungszeit die höchste Priorität, da sie einen Ist-Zustand des physikalischen Gebäudes am aktuellsten darstellen. Diese N Datenquellen werden deshalb bevorzugt zur weiteren Verarbeitung herangezogen. Die Verwendung der zeitlichen Priorität hat den Vorteil, dass die aktuellsten N Datenquellen jeweils zur Erfassung der Realdaten verwendet werden. Dies führt zu einem verbesserten aktualisierten digitalen Gebäudemodell.

Gemäß einer weiteren Ausführungsform wird als die Priorität eine Genauigkeits-Priorität zur Angabe einer Genauigkeit der von der Datenquelle erhaltenen Realdaten verwendet, wobei zumindest eine der N Datenquellen in Abhängigkeit der zugeordneten Genauigkeits-Prioritäten zum Erfassen der Realdaten ausgewählt wird.

Bei einer Genauigkeitspriorität wird von zumindest zwei Datenquellen, wie beispielsweise zwei Kameras, insbesondere diejenige Datenquelle, also diejenige Kamera verwendet, bei welcher die Genauigkeit der Daten am höchsten ist. Bei der Genauigkeit der Daten einer Videokamera geht es vorzugsweise darum, zu bestimmen, welche Videokamera eine reale begehbare Fläche exakter darstellt. Dies führt zu einem verbesserten aktualisierten digitalen Gebäudemodell.

Gemäß einer weiteren Ausführungsform wird als die Priorität eine Datenquellentyp-Priorität zur Angabe eines Datenquellentyps der von der Datenquelle erhaltenen Realdaten verwendet, wobei zumindest eine der N Datenquellen in Abhängigkeit der zugeordneten Datenquellentyp-Prioritäten zum Erfassen der Realdaten ausgewählt wird.

Bei der Datenquellentyp-Priorität werden insbesondere zumindest zwei Datenquellen miteinander verglichen, wobei beispielsweise ein Datenquellentyp eine mobile Datenquelle und ein Datentyp eine verbaute Datenquelle ist. Dabei wird vorzugsweise über einen Vergleich ermittelt, welcher der zumindest zwei Datentypen eine höhere Genauigkeit hinsichtlich der Erfassung der realen begehbaren Fläche des physikalischen Gebäudes aufweist. Der Datenquellentyp mit der höheren Genauigkeit wird zur Erfassung der Realdaten verwendet. Beispielsweise können verbaute Daten von einer Videokamera exakter, als mobile Daten eines tragbaren Endgerätes sein. Demnach werden in diesem Fall die Daten der Videokamera als Datenquelle zum Erfassen von Realdaten verwendet. Dies führt zu einem verbesserten aktualisierten digitalen Gebäudemodell.

Gemäß einer weiteren Ausführungsform wird aus den Prioritäten eine Kombination aus zumindest zwei Prioritäten zum Erfassen der Realdaten ausgewählt, wobei die Prioritäten die zeitliche Priorität, die Genauigkeits-Priorität und die Datenquellentyp-Priorität umfassen.

Bei der Kombination werden zumindest insbesondere zwei Prioritäten zum Erfassen der Realdaten ausgewählt. Beispielsweise wird die Datenquelle ausgewählt oder die Datenquellen, welche bei der zeitlichen Priorität die höchste Genauigkeit aufweisen. Anschließend wird die Datenquelle oder die Datenquellen verwendet, welche bei der Genauigkeitspriorität die höchste Genauigkeit aufweisen. Insbesondere werden nun die aktuellste oder die aktuellsten Datenquellen der zeitlichen Priorität mit beispielweise der Datenquelle oder den Datenquellen, welche die höchste Genauigkeit aufweisen, kombiniert.

Dies führt zu einem verbesserten aktualisierten digitalen Gebäudemodell. Die Kombination kann beispielsweise zwei, drei, vier oder mehr Prioritäten und/oder Datenquellen umfassen. Gemäß einer weiteren Ausführungsform wird eine Häufigkeit der Verwendung von mobilen Datenquellen zum Erfassen der Realdaten aus zumindest einer der realen begehbaren Flächen innerhalb des physikalischen Gebäudes erhalten, um zumindest eine der virtuell begehbaren Flächen innerhalb des digitalen Gebäudemodells mittels der erfassten Realdaten zu aktualisieren.

Die Häufigkeit der Verwendung von mobilen Datenquellen bezeichnet insbesondere eine absolute Häufigkeit. Die absolute Häufigkeit ist vorzugsweise im Fall einer schnellen Evakuierung von Personen aus dem physikalischen Gebäude und/oder zur Erstellung von aktualisierten Evakuierungsplänen von physikalischen Gebäuden mittels des aktualisierten digitalen Gebäudemodells von Bedeutung.

Die Häufigkeit kennzeichnet insbesondere eine absolute Häufigkeit, bei welcher beispielsweise eine Vielzahl von Benutzern mit mobilen Endgeräten, beispielsweise 40 Benutzer, bei denen insbesondere die Bewegungsdaten und/oder Positionsdaten aufgezeichnet werden, sich über eine bestimmte reale begehbare Fläche bewegen und/oder bewegt haben. Die Häufigkeit gibt somit an, wie oft ein Benutzer oder die Vielzahl von Benutzern über eine bestimmte reale begehbare Fläche, insbesondere Flure, Treppen und/oder Räume, innerhalb eines bestimmten Zeitraums, wie beispielsweise eine Woche oder einen Monat, sich bewegt haben. Beispielsweise werden mehrere reale begehbare Flächen, wie Flure, verglichen. Insbesondere der Flur aus einer Vielzahl von Fluren innerhalb des physikalischen Gebäudes, über welchen sich die meisten Benutzer bewegen oder bewegt haben, hat somit die höchste Häufigkeit und wird daher als bevorzugte Datenquelle verwendet.

Dadurch kann abgeleitet werden, welche begehbaren Flächen den Benutzern vertraut sind und/oder welche begehbaren Flächen von den Benutzern vorzugsweise verwendet werden.

Dies hat den Vorteil, dass die Evakuierungssimulation verbessert werden kann, da die vertrauten Wege, welche von dem Benutzer oder der Vielzahl von Benutzern verwendet werden, bekannt sind. Dies verbessert die Evakuierungssituation im Falle einer Evakuierung und erhöht somit die Sicherheit des Benutzers und/oder der Benutzer im physikalischen Gebäude. Insbesondere kann bei Verwendung der vertrauten Wege untersucht werden, ob die vertrauten Wege im Falle einer Evakuierung nicht überlastet sind, da beispielsweise eine Vielzahl an Personen nur die vertrauten Wege benutzen. Zusätzlich wird mittels der mobilen Datenquellen ein verbessertes, aktualisiertes digitales Gebäudemodell bereitgestellt.

Gemäß einer weiteren Ausführungsform ist das digitale Gebäudemodell als ein digitales Gebäudemodell mit mehreren einzelnen nicht miteinander verbundenen Gebäuden und/oder als ein digitales Gebäudemodell mit mehreren miteinander verbundenen Gebäuden und/oder als Teil eines digitalen Campus- und/oder Stadtplans ausgebildet.

Gemäß einer weiteren Ausführungsform ist die begehbare Fläche als ein Flur und/oder als ein Korridor und/oder als ein Raum und/oder als eine Treppe und/oder als ein Aufzug und/oder als ein bestimmter Gebäudeteil des digitalen Gebäudemodells und/oder des physikalischen Gebäudes und/oder als ein Weg und/oder eine Straße und/oder ein Platz zwischen zumindest zwei digitalen Gebäuden des digitalen Gebäudemodells und/oder zwischen zumindest zwei physikalischen Gebäuden ausgebildet.

Insbesondere ist die begehbare Fläche als ein Weg und/oder eine Straße ausgebildet, wobei der Weg und/oder die Straße beispielsweise innerhalb eines physikalischen Campus angeordnet sein kann und zumindest zwei physikalische Gebäude miteinander verbindet. Vorzugsweise ist der Weg und/oder die Straße innerhalb des digitalen Campusplans angeordnet und verbindet zumindest zwei digitale Gebäude aus dem digitalen Campusplan.

Um insbesondere die virtuell begehbaren Flächen innerhalb des digitalen Gebäudemodells, also beispielsweise die räumlichen Umrisse und/oder eine Anzahl der Stufen einer Treppe, mittels erfasster Realdaten möglichst exakt zu aktualisieren, werden im Folgenden im Detail verschiedene Möglichkeiten für die einzelnen Typen der begehbaren Flächen beschrieben.

Insbesondere werden für die Aktualisierung der virtuell begehbaren Flächen, wie beispielsweise Flure, Treppen, Aufzüge und Räume, mehrere der N Datenquellen sowie mehrere der Datenquellentypen verwendet, um mittels dieser aus dem realen physikalischen Gebäude Realdaten zur Aktualisierung zu erhalten.

Hinsichtlich der exakten Darstellung der digitalen Flure ist es vorteilhaft die jeweilige Breite der realen Flure zu ermitteln. Hierbei werden insbesondere aus dem vorhandenen digitalen Gebäudemodell die BIM/IFC-Daten in Bezug auf die digitalen Flure extrahiert. Diese werden insbesondere mit erfassten Realdaten aus den mobilen Datenquellen und den verbauten Datenquellen von den realen Fluren zusammengeführt. Durch die Zusammenführung kann insbesondere die Darstellung der digitalen Flure durch die Kombination mit den BIM/IFC Daten angenähert werden. Um diese Annäherung weiter zu verbessern, werden insbesondere eine Vielzahl von mobilen und/oder verbauten Datenquellen, hinzugenommen. Dies führt zu einem verbesserten aktualisierten digitalen Gebäudemodell, insbesondere der virtuell begehbaren Flächen wie der digitalen Flure.

Hinsichtlich der digitalen Treppen und digitalen Aufzüge ist es vorteilhaft, die genaue Anzahl der realen Stufen und die genaue Anzahl der realen Stockwerke, welche der reale Aufzug abfährt, zu ermitteln.

Hierbei werden insbesondere aus dem vorhandenen digitalen Gebäudemodell die BIM/IFC-Daten in Bezug auf die digitalen Treppen und digitalen Aufzüge extrahiert. Diese extrahierten BIM/IFC-Daten werden vorzugsweise mit den erfassten Realdaten aus einem oder mehreren der bereits vorgestellten Scanverfahren von realen begehbaren Flächen, insbesondere von realen Treppen und Aufzügen, zusammengeführt. Im Detail werden hierbei die Eintritts- und Austrittspunkte der Benutzer auf einem jeweiligen Stockwerk aus den erfassten Realdaten bestimmt. Dadurch kann insbesondere abgeleitet werden, wie viele Stufen eine Treppe genau umfasst, wie breit eine Stufe einer Treppe ist und/oder welche Stockwerke einen Aufzug umfassen. Diese Zusammenführung führt zu einem verbesserten aktualisierten digitalen Gebäudemodell, insbesondere der virtuell begehbaren Flächen, wie der digitalen Treppen und Aufzüge.

Hinsichtlich der digitalen Räume ist es vorteilhaft, die genauen Türen und Öffnungen der realen Räume zu ermitteln. Hierbei werden insbesondere aus dem vorhandenen digitalen Gebäudemodell die BIM/IFC-Daten in Bezug auf die digitalen Räume und deren Türinformationen insbesondere aus einer Objektklasse "IfcDoor", welche beispielsweise die Breite der Tür und einen Zustand angeben, ob die Tür geöffnet oder geschlossen ist, extrahiert. Diese extrahierten BIM/IFC-Daten werden vorzugsweise mit den erfassten Realdaten aus einem oder mehreren der bereits vorgestellten Scanverfahren von den realen begehbaren Räumen zusammengeführt.

Im Detail werden dabei der oder die Eintrittspunkte in den jeweiligen digitalen Raum aus den erfassten Realdaten bestimmt, da Türen und Öffnungen in dem BIM/IFC-Modell meistens unvollständig modelliert sind, jedoch der digitale Raum in dem BIM/IFC-Modell annähernd exakt modelliert ist. Diese Zusammenführung führt zu einem verbesserten aktualisierten digitalen Gebäudemodell, insbesondere der virtuell begehbaren Flächen wie der digitalen Räume.

Gemäß einer weiteren Ausführungsform umfasst das Verfahren die folgenden Schritte:
e) Durchführen einer aktualisierten Personenstromsimulation basierend auf dem aktualisierten digitalen Gebäudemodell,
f) Vergleichen von virtuell begehbaren Flächen einer früheren Personenstromsimulation mit den virtuell begehbaren Flächen der aktualisierten Personenstromsimulation, und
g) Absetzen einer Sicherheitswarnung in Abhängigkeit einer Abweichung zwischen den virtuell begehbaren Flächen der früheren Personenstromsimulation und den virtuell begehbaren Flächen der aktualisierten Personenstromsimulation.

Gemäß einem zweiten Aspekt wird ein Computerprogrammprodukt vorgeschlagen, welches auf einer programmgesteuerten Einrichtung die Durchführung des wie oben erläuterten Verfahrens veranlasst.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß einem dritten Aspekt wird eine Vorrichtung zum Bereitstellen eines aktualisierten digitalen Gebäudemodells vorgeschlagen. Die Vorrichtung umfasst eine Bereitstellungs-Einheit, welche dazu eingerichtet ist, ein digitales Gebäudemodell für ein physikalisches Gebäude bereitzustellen, eine Ermittlungs-Einheit, welche dazu eingerichtet ist, eine virtuell begehbare Fläche innerhalb des digitalen Gebäudemodells zu ermitteln, eine Erfassungs-Einheit, welche dazu eingerichtet ist, Realdaten, welche mittels einer Anzahl N von Datenquellen erhalten werden, mit N ≥ 1, zu erfassen, wobei die Realdaten Daten von einer mit der virtuell begehbaren Fläche korrespondierenden realen begehbaren Fläche innerhalb des physikalischen Gebäudes umfassen, und eine Aktualisierungs-Einheit, welche dazu eingerichtet ist, die virtuell begehbare Fläche innerhalb des digitalen Gebäudemodells mittels der erfassten Realdaten der realen begehbaren Fläche zu aktualisieren, um das aktualisierte digitale Gebäudemodell bereitzustellen.

Die jeweilige Einheit, zum Beispiel die Erfassungs-Einheit oder die Aktualisierungs-Einheit, kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Die für das vorgeschlagene Verfahren beschriebenen Ausführungsformen und Merkmale gelten für die vorgeschlagene Vorrichtung entsprechend.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
- Fig. 1: zeigt ein schematisches Ablaufdiagramm eines Ausführungsbeispiels eines Verfahrens zum Bereitstellen eines aktualisierten digitalen Gebäudemodells; und
- Fig. 2: zeigt ein schematisches Blockdiagramm eines Ausführungsbeispiels einer Vorrichtung zum Bereitstellen eines aktualisierten digitalen Gebäudemodells.

In den Figuren sind gleiche oder funktionsgleiche Elemente mit denselben Bezugszeichen versehen worden, sofern nichts anderes angegeben ist.

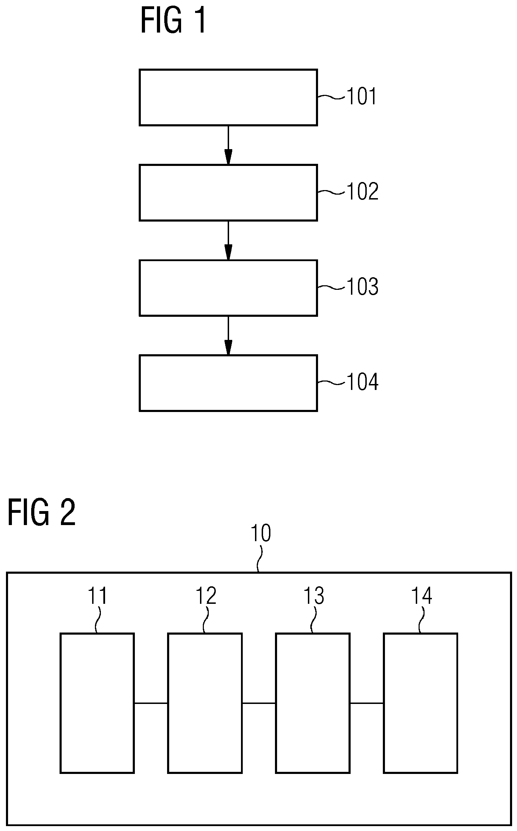

Fig. 1 zeigt ein schematisches Ablaufdiagramm eines Ausführungsbeispiels eines Verfahrens zum Bereitstellen eines aktualisierten digitalen Gebäudemodells.

Das Ausführungsbeispiel der Fig. 1 umfasst die folgenden Verfahrensschritte 101 bis 104:
In dem Schritt 101 wird ein digitales Gebäudemodell für ein physikalisches Gebäude bereitgestellt.

Das digitale Gebäudemodell ist insbesondere als ein digitales Gebäudemodell mit mehreren einzelnen nicht miteinander verbundenen Gebäuden und/oder als ein digitales Gebäudemodell mit mehreren miteinander verbundenen Gebäuden und/oder als Teil eines digitalen Stadtplans ausgebildet.

In dem Schritt 102 wird eine virtuell begehbare Fläche innerhalb des digitalen Gebäudemodells ermittelt.

Die begehbare Fläche ist insbesondere als ein Flur und/oder als ein Korridor und/oder als ein Raum und/oder als eine Treppe und/oder als ein Aufzug und/oder als ein bestimmter Gebäudeteil des digitalen Gebäudemodells und/oder des physikalischen Gebäudes und/oder als ein Weg und/oder eine Straße und/oder ein Platz zwischen zumindest zwei digitalen Gebäuden des digitalen Gebäudemodells und/oder zwischen zumindest zwei physikalischen Gebäuden ausgebildet.

Die virtuell begehbare Fläche des digitalen Gebäudemodells wird insbesondere mittels digitaler Planungsdaten aus dem digitalen Gebäudemodell ermittelt, und/oder mittels eines Scanverfahrens, bei welchem die reale begehbare Fläche innerhalb des physikalischen Gebäudes gescannt wird, aus dem physikalischen Gebäude ermittelt, und/oder mittels zumindest einer mobilen Datenquelle, welche Bewegungsdaten von zumindest einem Benutzer der realen begehbaren Fläche innerhalb des physikalischen Gebäudes bereitstellt, aus dem physikalischen Gebäude ermittelt.

In dem Schritt 103 werden Realdaten erfasst, welche mittels einer Anzahl N von Datenquellen erhalten werden, mit N ≥ 1, wobei die Realdaten Daten von einer mit der virtuell begehbaren Fläche korrespondierenden realen begehbaren Fläche innerhalb des physikalischen Gebäudes umfassen.

Jede der N Datenquellen ist insbesondere als ein bestimmter Datenquellentyp ausgebildet, wobei der bestimmte Datenquellentyp die mobile Datenquelle oder eine verbaute Datenquelle umfasst.

Die Anzahl N von Datenquellen ist vorzugsweise N ≥ 2.

Jeder der N Datenquellen wird insbesondere eine jeweilige Priorität zugeordnet, wobei zumindest eine der N Datenquellen in Abhängigkeit der zugeordneten Prioritäten zum Erfassen der Realdaten ausgewählt wird.

Insbesondere wird als die Priorität eine zeitliche Priorität zur Angabe einer Aktualität der von der Datenquelle erhaltenen Realdaten verwendet, wobei zumindest eine der N Datenquellen in Abhängigkeit der zugeordneten zeitlichen Prioritäten zum Erfassen der Realdaten ausgewählt wird.

Vorzugsweise wird als die Priorität eine Genauigkeits-Priorität zur Angabe einer Genauigkeit der von der Datenquelle erhaltenen Realdaten verwendet, wobei zumindest eine der N Datenquellen in Abhängigkeit der zugeordneten Genauigkeits-Prioritäten zum Erfassen der Realdaten ausgewählt wird.

Insbesondere wird als die Priorität eine Datenquellentyp-Priorität zur Angabe eines Datenquellentyps der von der Datenquelle erhaltenen Realdaten verwendet, wobei zumindest eine der N Datenquellen in Abhängigkeit der zugeordneten Datenquellentyp-Prioritäten zum Erfassen der Realdaten ausgewählt wird.

Vorzugsweise wird aus den Prioritäten eine Kombination aus zumindest zwei Prioritäten zum Erfassen der Realdaten ausgewählt, wobei die Prioritäten die zeitliche Priorität, die Genauigkeits-Priorität und die Datenquellentyp-Priorität umfassen.

In dem Schritt 104 wird die virtuell begehbare Fläche innerhalb des digitalen Gebäudemodells mittels der erfassten Realdaten der realen begehbaren Fläche aktualisiert, um das aktualisierte digitale Gebäudemodell bereitzustellen.

Insbesondere wird eine Häufigkeit der Verwendung von mobilen Datenquellen zum Erfassen der Realdaten aus zumindest einer der realen begehbaren Flächen innerhalb des physikalischen Gebäudes erhalten, um zumindest eine der virtuell begehbaren Flächen innerhalb des digitalen Gebäudemodells mittels der erfassten Realdaten zu aktualisieren.

Fig. 2 zeigt ein schematisches Blockdiagramm eines Ausführungsbeispiels einer Vorrichtung 10 zum Bereitstellen eines aktualisierten digitalen Gebäudemodells. Die Vorrichtung 10 umfasst eine Bereitstellungs-Einheit 11, eine Ermittlungs-Einheit 12, eine Erfassungs-Einheit 13 sowie eine Aktualisierungs-Einheit 14.

Die Bereitstellungs-Einheit 11 ist dazu eingerichtet, ein digitales Gebäudemodell für ein physikalisches Gebäude bereitzustellen.

Die Ermittlungs-Einheit 12 ist dazu eingerichtet, eine virtuell begehbare Fläche innerhalb des digitalen Gebäudemodells zu ermitteln.

Die Erfassungs-Einheit 13 ist dazu eingerichtet, Realdaten, welche mittels einer Anzahl N von Datenquellen erhalten werden, mit N ≥ 1, zu erfassen, wobei die Realdaten Daten von einer mit der virtuell begehbaren Fläche korrespondierenden realen begehbaren Fläche innerhalb des physikalischen Gebäudes umfassen.

Die Aktualisierungs-Einheit 14 ist dazu eingerichtet, die virtuell begehbare Fläche innerhalb des digitalen Gebäudemodells mittels der erfassten Realdaten der realen begehbaren Fläche zu aktualisieren, um das aktualisierte digitale Gebäudemodell bereitzustellen.

Obwohl die vorliegende Erfindung anhand von Ausführungsbeispielen beschrieben wurde, ist sie vielfältig modifizierbar.

## Patentansprüche

1. Verfahren zum Bereitstellen eines aktualisierten digitalen Gebäudemodells, mit den Schritten:
a) Bereitstellen (101) eines digitalen Gebäudemodells für ein physikalisches Gebäude,
b) Ermitteln (102) einer virtuell begehbaren Fläche innerhalb des digitalen Gebäudemodells,
c) Erfassen von Realdaten (103), welche mittels einer Anzahl N von Datenquellen erhalten werden, mit N ≥ 1, wobei die Realdaten Daten von einer mit der virtuell begehbaren Fläche korrespondierenden realen begehbaren Fläche innerhalb des physikalischen Gebäudes umfassen, und
d) Aktualisieren (104) der virtuell begehbaren Fläche innerhalb des digitalen Gebäudemodells mittels der erfassten Realdaten der realen begehbaren Fläche zur Bereitstellung des aktualisierten digitalen Gebäudemodells.

2. Verfahren nach Anspruch 1,
**dadurch gekennzeichnet,**
**dass** die virtuell begehbare Fläche des digitalen Gebäudemodells mittels digitaler Planungsdaten aus dem digitalen Gebäudemodell ermittelt wird, und/oder mittels eines Scanverfahrens, bei welchem die reale begehbare Fläche innerhalb des physikalischen Gebäudes gescannt wird, aus dem physikalischen Gebäude ermittelt wird, und/oder mittels zumindest einer mobilen Datenquelle, welche Bewegungsdaten von zumindest einem Benutzer der realen begehbaren Fläche innerhalb des physikalischen Gebäudes bereitstellt, aus dem physikalischen Gebäude ermittelt wird.

3. Verfahren nach Anspruch 1 oder 2,
**dadurch gekennzeichnet,**
**dass** jede der N Datenquellen als ein bestimmter Datenquellentyp ausgebildet ist, wobei der bestimmte Datenquellentyp die mobile Datenquelle oder eine verbaute Datenquelle umfasst.

4. Verfahren nach einem der Ansprüche 1 bis 3,
**dadurch gekennzeichnet,**
**dass** die Anzahl N von Datenquellen N ≥ 2 ist.

5. Verfahren nach Anspruch 4,
**dadurch gekennzeichnet,**
**dass** jeder der N Datenquellen eine jeweilige Priorität zugeordnet wird, wobei zumindest eine der N Datenquellen in Abhängigkeit der zugeordneten Prioritäten zum Erfassen der Realdaten ausgewählt wird.

6. Verfahren nach Anspruch 5,
**dadurch gekennzeichnet,**
**dass** als die Priorität eine zeitliche Priorität zur Angabe einer Aktualität der von der Datenquelle erhaltenen Realdaten verwendet wird, wobei zumindest eine der N Datenquellen in Abhängigkeit der zugeordneten zeitlichen Prioritäten zum Erfassen der Realdaten ausgewählt wird.

7. Verfahren nach Anspruch 5,
**dadurch gekennzeichnet,**
**dass** als die Priorität eine Genauigkeits-Priorität zur Angabe einer Genauigkeit der von der Datenquelle erhaltenen Realdaten verwendet wird, wobei zumindest eine der N Datenquellen in Abhängigkeit der zugeordneten Genauigkeits-Prioritäten zum Erfassen der Realdaten ausgewählt wird.

8. Verfahren nach Anspruch 5,
**dadurch gekennzeichnet,**
**dass** als die Priorität eine Datenquellentyp-Priorität zur Angabe eines Datenquellentyps der von der Datenquelle erhaltenen Realdaten verwendet wird, wobei zumindest eine der N Datenquellen in Abhängigkeit der zugeordneten Datenquellentyp-Prioritäten zum Erfassen der Realdaten ausgewählt wird.

9. Verfahren nach den Ansprüchen 5 bis 8,
**dadurch gekennzeichnet,**
**dass** aus den Prioritäten eine Kombination aus zumindest zwei Prioritäten zum Erfassen der Realdaten ausgewählt wird, wobei die Prioritäten die zeitliche Priorität, die Genauigkeits-Priorität und die Datenquellentyp-Priorität umfassen.

10. Verfahren nach einem der Ansprüche 3 bis 9,
**dadurch gekennzeichnet,**
**dass** eine Häufigkeit der Verwendung von mobilen Datenquellen zum Erfassen der Realdaten aus zumindest einer der realen begehbaren Flächen innerhalb des physikalischen Gebäudes erhalten wird, um zumindest eine der virtuell begehbaren Flächen innerhalb des digitalen Gebäudemodells mittels der erfassten Realdaten zu aktualisieren.

11. Verfahren nach einem der Ansprüche 1 bis 10,
**dadurch gekennzeichnet,**
**dass** das digitale Gebäudemodell als ein digitales Gebäudemodell mit mehreren einzelnen nicht miteinander verbundenen Gebäuden und/oder als ein digitales Gebäudemodell mit mehreren miteinander verbundenen Gebäuden und/oder als Teil eines digitalen Campus- und/oder Stadtplans ausgebildet ist.

12. Verfahren nach einem der Ansprüche 1 bis 11,
**dadurch gekennzeichnet,**
**dass** die begehbare Fläche als ein Flur und/oder als ein Korridor und/oder als ein Raum und/oder als eine Treppe und/oder als ein Aufzug und/oder als ein bestimmter Gebäudeteil des digitalen Gebäudemodells und/oder des physikalischen Gebäudes und/oder als ein Weg und/oder eine Straße und/oder ein Platz zwischen zumindest zwei digitalen Gebäuden des digitalen Gebäudemodells und/oder zwischen zumindest zwei physikalischen Gebäuden ausgebildet ist.

13. Verfahren nach einem der Ansprüche 1 bis 12, **gekennzeichnet durch**,
e) Durchführen einer aktualisierten Personenstromsimulation basierend auf dem aktualisierten digitalen Gebäudemodell,
f) Vergleichen von virtuell begehbaren Flächen einer früheren Personenstromsimulation mit den virtuell begehbaren Flächen der aktualisierten Personenstromsimulation, und
g) Absetzen einer Sicherheitswarnung in Abhängigkeit einer Abweichung zwischen den virtuell begehbaren Flächen der früheren Personenstromsimulation und den virtuell begehbaren Flächen der aktualisierten Personenstromsimulation.

14. Computerprogrammprodukt, welches auf einer programmgesteuerten Einrichtung die Durchführung des Verfahrens nach einem der Ansprüche 1 bis 13 veranlasst.

15. Vorrichtung (10) zum Bereitstellen eines aktualisierten digitalen Gebäudemodells, mit:
- einer Bereitstellungs-Einheit (11), welche dazu eingerichtet ist, ein digitales Gebäudemodell für ein physikalisches Gebäude bereitzustellen,
- einer Ermittlungs-Einheit (12), welche dazu eingerichtet ist, eine virtuell begehbare Fläche innerhalb des digitalen Gebäudemodells zu ermitteln,
- einer Erfassungs-Einheit (13), welche dazu eingerichtet ist, Realdaten, welche mittels einer Anzahl N von Datenquellen erhalten werden, mit N ≥ 1, zu erfassen, wobei die Realdaten Daten von einer mit der virtuell begehbaren Fläche korrespondierenden realen begehbaren Fläche innerhalb des physikalischen Gebäudes umfassen, und
- einer Aktualisierungs-Einheit (14), welche dazu eingerichtet ist, die virtuell begehbare Fläche innerhalb des digitalen Gebäudemodells mittels der erfassten Realdaten der realen begehbaren Fläche zu aktualisieren, um das aktualisierte digitale Gebäudemodell bereitzustellen.
